# EUROPEAN PATENT APPLICATION

(11) **EP 3 020 765 A1**
(43) Date of publication of application: **18.05.2016**
(21) Application number: 14834644.8
(22) Date of filing: 12.06.2014
(51) Int. Cl.: C08L 83/07, C08L 83/05, C08L 83/06, C08K 5/5419, H01L 23/29, H01L 23/31, H01L 33/56

(54) **CURABLE RESIN COMPOSITION**

(30) Priority: 09.08.2013 JP 2013166227
(71) Applicant: The Yokohama Rubber Company, Limited, Tokyo 105-8685 (JP)
(72) Inventor: TAKEI Yoshihito, Hiratsuka City Kanagawa 254-8601 (JP); KIM Emi, Hiratsuka City Kanagawa 254-8601 (JP); SAIKI Takeaki, Hiratsuka City Kanagawa 254-8601 (JP)
(74) Representative: Dilg, Haeusler, Schindelmann Patentanwaltsgesellschaft mbH
(86) International application number: PCT/JP2014/065601
(87) International publication number: WO 2015/019705

(57) **Abstract**

Provided is a curable resin composition that can provide a cured product having good transparency and being capable of suppressing occurrence of spots. This curable resin composition contains a silicon-containing compound (A) having a silanol group and an aryl group, a silicon-containing compound (B) having at least two silicon atom-bonded hydrogen atoms and at least one aryl group in one molecule, a branched-chain organopolysiloxane (C) having an alkenyl group and an aryl group, and a hydrosilylation reaction catalyst (D).

## Description

### Technical Field

The present invention relates to a curable resin composition.

### Background Art

Curable resin compositions containing silicone resins have been known conventionally and have been used, for example, as compositions for sealing optical semiconductors such as light-emitting diodes (LEDs), which are for sealing optical semiconductors. For example, the following is described in
[Claim 1] of Patent Document 1: a curable organopolysiloxane composition comprising at least: (A) a branched-chain organopolysiloxane having in each molecule at least three alkenyl groups, at least 30 mol% of all silicon atom-bonded organic groups being aryl groups; (B) a straight-chain organopolysiloxane having aryl groups and having both molecular terminals capped with diorganohydrogensiloxy groups...; (C) a branched-chain organopolysiloxane having in each molecule at least three diorganohydrogensiloxy groups, at least 15 mol% of all silicon atom-bonded organic groups being aryl groups...; and (D) a hydrosilylation reaction catalyst....

### Citation List

### Patent Literature

Patent Document 1: Japanese Unexamined Patent Application Publication No. 2010-1336A

### Summary of Invention

### Technical Problem

Practically, Patent Document 1 only discloses substances having a degree of polymerization of 1 or approximately 6 to 7 as the component (B). The inventors of the present invention has revealed that such a "curable organopolysiloxane composition" disclosed in Patent Document 1 results in insufficient adhesion of the cured product. As a result of diligent research of the inventors of the present invention, it was found that adhesion is enhanced by using a curable resin composition in which a branched-chain organopolysiloxane having an alkenyl group and a straight-chain organopolysiloxane having at least two silicon atom-bonded hydrogen atoms are used in combination and in which the degree of polymerization of the straight-chain organopolysiloxane is "greater than 10".

An extremely small dice-like chip having two types of semiconductors bonded to each other is called an "LED chip", and an assembly in which an LED chip is enclosed and facilitated to connect to a circuit board is called an "LED package". As structures of LED packages, a chip on board (COB) type, in which a plurality of LED chips is directly mounted and enclosed on a circuit board, as well as shell type or surface-mounted type have been conventionally known. Since the COB type package is a relatively large LED package, a large amount of resin is used for sealing.

The inventors of the present invention conducted an investigation using the above-described curable resin composition containing the above-described straight-chain organopolysiloxane having the degree of polymerization of "greater than 10" as a sealing material for sealing such LEDs for COB type package. Specifically, this composition was cured after a phosphor was added, and the cured product was evaluated. As a result, some cases caused spots in the cured product. If spots are generated, appearance or brightness may be significantly impaired.
The inventors of the present invention conceived that the generation of spots is due to precipitation of phosphors, and thus added silica such as fumed silica to the curable resin composition described above from the perspective of preventing the precipitation of phosphors. As a result, although effects of suppressing generation of spots were observed, it was found that transparency, which is required for a sealing material for optical semiconductors, may be impaired.

In light of the problems described above, an object of the present invention is to provide a curable resin composition that can provide a cured product having good transparency and being capable of suppressing occurrence of spots.

### Solution to Problem

As a result of diligent research to achieve the above object, the inventors of the present invention have found that, by further adding an organopolysiloxane having a silanol group to the curable resin composition, a cured product in which occurrence of spots is suppressed while excellent transparency is maintained can be obtained, and thus completed the present invention.

Specifically, the present invention provides the following (1) to (5).
(1) A curable resin composition comprising: a silicon-containing compound having a silanol group and an aryl group (A); a silicon-containing compound having at least two silicon atom-bonded hydrogen atoms and at least one aryl group in one molecule (B); a branched-chain organopolysiloxane having an alkenyl group and an aryl group (C); and a hydrosilylation reaction catalyst (D).
(2) The curable resin composition according to (1) described above, where the silicon-containing compound (A) is a straight-chain organopolysiloxane represented by formula (A1) below.
(3) The curable resin composition according to (1) or (2) described above, where the branched-chain organopolysiloxane (C) is an organopolysiloxane represented by average unit formula (C1) below.
(4) The curable resin composition according to any one of (1) to (3) described above, further comprising a low-viscosity organopolysiloxane (E) having a viscosity of 50,000 mPa·s or less at 25°C.
(5) The curable resin composition according to any one of (1) to (4) described above, where the composition is a composition for sealing an optical semiconductor element.

### Advantageous Effect of Invention

According to the present invention, a curable resin composition that can provide a cured product having good transparency and being capable of suppressing the occurrence of spots can be provided.

### Description of Embodiments

The curable resin composition of the present invention (hereinafter, also referred to as "composition of the present invention") is a curable resin composition comprising: a silicon-containing compound having a silanol group and an aryl group (A); a silicon-containing compound having at least two silicon atom-bonded hydrogen atoms and at least one aryl group in one molecule (B); a branched-chain organopolysiloxane having an alkenyl group and an aryl group (C); and a hydrosilylation reaction catalyst (D).
Each component contained in the composition of the present invention will be described in detail hereinafter.

### Silicon-containing compound (A)

The silicon-containing compound (A) is a silicon-containing compound having a silanol group (Si-OH) and an aryl group. Unlike cases where fumed silica or the like is used, the composition of the present invention can suppress occurrence of spots due to phosphors while excellent transparency is maintained by allowing the silicon-containing compound having a silanol group (A) to be contained. Although the cause of this is not known, it is conceived that this is because the silanol group makes affinity of the silicon-containing compound (A) and the phosphor excellent, thereby enhancing dispersibility of phosphor, which becomes the cause of spots. However, cases where the above effect is obtained by other mechanisms are also included in the scope of the present invention.

Note that the silicon-containing compound (A) has at least one aryl group since damping of light that is caused by refraction, reflection, scattering, or the like of the resulting cured product is small. Examples of the aryl group include aryl groups having from 6 to 18 carbons such as a phenyl group, tolyl group, and xylyl group, and a phenyl group is preferable.

The silicon-containing compound (A) is not particularly limited as long as it is a compound having a silanol group and an aryl group. Therefore, the silicon-containing compound (A) may additionally have a substituted or unsubstituted monovalent hydrocarbon group; however, the silicon-containing compound (A), preferably, does not have an alkenyl group directly bonded to a silicon atom.

Examples of the silicon-containing compound (A) described above include silanes such as methylphenylsilanediol, ethylphenylsilanediol, n-propylphenylsilanediol, isopropylphenylsilanediol, n-butylphenylsilanediol, isobutylphenylsilanediol, tert-butylphenylsilanediol, diphenylsilanediol, ethylmethylphenylsilanol, n-propylmethylphenylsilanol, isopropylmethylphenylsilanol, n-butylmethylphenylsilanol, isobutylmethylphenylsilanol, tert-butylmethylphenylsilanol, ethyl-n-propylphenylsilanol, ethylisopropylphenylsilanol, n-butylethylphenylsilanol, isobutylethylphenylsilanol, tert-butylethylphenylsilanol, methyldiphenylsilanol, ethyldiphenylsilanol, n-propyldiphenylsilanol, isopropyldiphenylsilanol, n-butyldiphenylsilanol, isobutyldiphenylsilanol, tert-butyldiphenylsilanol, and phenylsilanetriol. One type of these may be used alone or two or more types of these may be used in combination.

Furthermore, the silicon-containing compound (A) may be an organopolysiloxane having a silanol group and an aryl group. Preferable examples of such an organopolysiloxane as the silicon-containing compound (A) include a straight-chain organopolysiloxane represented by formula (A1) below.

HOR¹¹₂SiO(R¹¹₂SiO)ₙ₁SiR¹¹₂OH ......................... (A1)

In formula (A1), each R¹¹ is independently a substituted or unsubstituted monovalent hydrocarbon group not having aliphatic unsaturated bonds. Examples of the monovalent hydrocarbon group of R¹¹ include alkyl groups having from 1 to 18 carbons such as a methyl group, ethyl group, n-propyl group, isopropyl group, n-butyl group, isobutyl group, sec-butyl group, tert-butyl group, various pentyl groups, various hexyl groups, various octyl groups, various decyl groups, cyclopentyl group, and cyclohexyl group; aryl groups having from 6 to 18 carbons such as a phenyl group, tolyl group, and xylyl group; aralkyl groups having from 7 to 18 carbons such as a benzyl group and phenethyl group; and halogenated alkyl groups having from 1 to 18 carbons such as a 3-chloropropyl group and 3,3,3-trifluoropropyl group. Of these, alkyl groups having from 1 to 18 carbons are preferable, and methyl groups (hereinafter, also referred to as "Me") are more preferable.
Note that at least one R¹¹ is an aryl group, and preferably a phenyl group (hereinafter, also referred to as "Ph").
In formula (A1), n1 is a positive number having an average value of 1 or greater, preferably a positive number of 1 to 1,000, and more preferably a positive number of 2 to 100.

Furthermore, the silicon-containing compound (A), which is an organopolysiloxane having a silanol group and an aryl group, may be a branched-chain organopolysiloxane as well as the straight-chain organopolysiloxane described above. In this branched-chain organopolysiloxane, the content of the silanol group is preferably from 0.0001 to 10% by mass, and more preferably from 0.01 to 5% by mass. Furthermore, preferably, at least 10 mol% of all silicon atom-bonded organic groups are aryl groups and, more preferably, at least 30 mol% thereof are aryl groups. Furthermore, the weight average molecular weight (Mw) is preferably from 500 to 5,000, and more preferably from 1,000 to 3,000. Examples of the branched-chain organopolysiloxane as the silicon-containing compound (A) include a branched-chain organopolysiloxane represented by average unit formula (A2) below.

(R¹²SiO_{3/2})a(R¹²₂SiO_{2/2})_{b}(R¹²₃SiO_{1/2})_{c}(SiO_{4/2})_{d}(X¹²O_{1/2})ₑ ......... (A2)

In formula (A2), each R¹² is independently a substituted or unsubstituted monovalent hydrocarbon group or hydroxy group (-OH). The monovalent hydrocarbon group of R¹² is synonymous with that described above for the monovalent hydrocarbon group of R¹¹. Furthermore, at least one R¹² in one molecule is an aryl group. Furthermore, when e is 0 or when e is a positive number and X¹² is not a hydrogen atom, at least one R¹² in one molecule is a hydroxy group.
In formula (A2), X¹² is a hydrogen atom or an alkyl group. Examples of the alkyl group include alkyl groups having from 1 to 18 carbons such as a methyl group, ethyl group, n-propyl group, isopropyl group, n-butyl group, isobutyl group, sec-butyl group, tert-butyl group, various pentyl groups, various hexyl groups, various octyl groups, various decyl groups, cyclopentyl group, and cyclohexyl group, and a methyl group is preferable. In formula (A2), a is a positive number; b is 0 or a positive number; c is 0 or a positive number; d is 0 or a positive number; e is 0 or a positive number; b/a is a number in a range of 0 to 10; c/a is a number in a range of 0 to 5; d/(a + b + c + d) is a number in a range of 0 to 0.3; and e/(a + b + c + d) is a number in a range of 0 to 0.4. As such a branched-chain organopolysiloxane having a silanol group and an aryl group, commercially available product can be used, and specific examples thereof include 217 Flake (manufactured by Dow Corning Toray Co., Ltd.) and the like.

As described above, examples of the silicon-containing compound
(A) include the silane, the straight-chain organopolysiloxane, and the branched-chain organopolysiloxane described above. One type of these may be used alone or two or more types of these may be used in combination.
At this time, from the perspective of achieving even better transparency of the cured product of the composition of the present invention, the straight-chain organopolysiloxane and the branched-chain organopolysiloxane are preferable.
From the perspective of achieving even better effect of suppressing occurrence of spots, the straight-chain organopolysiloxane is preferable.

Furthermore, from the perspective of achieving both even better transparency and even better effect of suppressing occurrence of spots, the straight-chain organopolysiloxane is preferable.

The content of the silicon-containing compound (A) is preferably from 5 to 90 parts by mass, and more preferably from 10 to 60 parts by mass, per 100 parts by mass total of the silicon-containing compound (B) and the branched-chain organopolysiloxane (C) described below from the perspective of achieving even better dispersibility of phosphors.

### Silicon-containing compound (B)

The silicon-containing compound (B) is a silicon-containing compound having at least two silicon atom-bonded hydrogen atoms (Si-H) and at least one aryl group in one molecule.
The silicon-containing compound (B) is subjected to an addition reaction (hydrosilylation reaction) with respect to the alkenyl group of the branched-chain organopolysiloxane (C) described below. At this time, since the silicon-containing compound (B) has at least two silicon atom-bonded hydrogen atoms, it can function as a crosslinking agent for the branched-chain organopolysiloxanes (C).
Note that the silicon-containing compound (B) has at least one aryl group since damping of light that is caused by refraction, reflection, scattering, or the like of the resulting cured product is small. Examples of the aryl group include aryl groups having from 6 to 18 carbons such as a phenyl group, tolyl group, and xylyl group, and a phenyl group is preferable.

Examples of the silicon-containing compound (B) include silanes such as tetraphenyldisilane (1,1,2,2-tetraphenyldisilane), diphenylsilane, and phenylsilane. One type of these may be used alone or two or more types of these may be used in combination.

Furthermore, the silicon-containing compound (B) may be a straight-chain organopolysiloxane having at least two silicon atom-bonded hydrogen atoms (Si-H) and at least one aryl group in one molecule (hereinafter, also referred to as "straight-chain organopolysiloxane (B)" for convenience).
From the perspectives of achieving superior adhesion of the cured product of the composition of the present invention and better handleability, the degree of polymerization of the straight-chain organopolysiloxane (B) is preferably greater than 10, more preferably greater than 30, and even more preferably greater than 30 but 1,000 or less, and particularly preferably greater than 30 but 500 or less.
In this specification, the degree of polymerization of the straight-chain organopolysiloxane is equivalent to a value determined by subtracting the number of the two silicon atoms on both terminals from the number of silicon atoms in the straight-chain organopolysiloxane.
For example, when the straight-chain organopolysiloxane (B) is an organopolysiloxane represented by formula (B1) described below, the degree of polymerization is a value expressed by n2 in formula (B1).

Such a straight-chain organopolysiloxane (B) is preferably a straight-chain organopolysiloxane having both molecular terminals capped with diorganohydrogensiloxy groups, and examples thereof include organopolysiloxanes represented by formula (B1) below.

HR²¹₂SiO(R²¹₂SiO)ₙ₂SiR²¹₂H... (B1)

In formula (B1), each R²¹ is independently a substituted or unsubstituted monovalent hydrocarbon group not having aliphatic unsaturated bonds. The monovalent hydrocarbon group of R²¹ is synonymous with that described above for the monovalent hydrocarbon group of R¹¹.
Note that at least one R²¹ is an aryl group and, preferably, at least 30 mol% are aryl groups and, more preferably, at least 40 mol% are aryl groups. The aryl groups are aryl groups having from 6 to 18 carbons and are preferably phenyl groups.

In formula (B1), n2 is a positive number having an average value of 1 or greater, preferably a positive number of greater than 10, more preferably a positive number of greater than 30, even more preferably a positive number of greater than 30 but 1,000 or less, and particularly preferably a positive number of greater than 30 but 500 or less. When n is within the ranges described above, the adhesion of the cured product is excellent.

From the perspective of ensuring that toughness is generated in the cured product, the weight average molecular weight (Mw) of the straight-chain organopolysiloxane (B) is preferably from 500 to 1,000,000 and more preferably from 1,000 to 150,000.
In the present invention, the weight average molecular weight is the weight average molecular weight indicated by the molecular weight of polystyrene as determined by gel permeation chromatography (GPC) using chloroform as a solvent.
Furthermore, the viscosity of the straight-chain organopolysiloxane (B) at 25°C is preferably from 20 to 1,000,000 mPa·s, and more preferably from 200 to 100,000 mPa·s.
Furthermore, in the present invention, viscosity is measured at 25°C in accordance with section 4.1 (Brookfield rotational viscometer) of JIS K7117-1.

Furthermore, the silicon-containing compound (B) may also be a branched-chain organopolysiloxane having at least two silicon atom-bonded hydrogen atoms and at least one aryl group in one molecule as well as the straight-chain organopolysiloxane (B) described above.
In this branched-chain organopolysiloxane, the content of the silicon atom-bonded hydrogen atom is preferably from 0.00001 to 2% by mass, and more preferably from 0.01 to 1% by mass. Furthermore, preferably, at least 10 mol% of all silicon atom-bonded organic groups are aryl groups and, more preferably, at least 30 mol% thereof are aryl groups.

Furthermore, the weight average molecular weight (Mw) is preferably from 500 to 5,000, and more preferably from 1,000 to 3,000.
Examples of the branched-chain organopolysiloxane as the silicon-containing compound (B) include branched-chain organopolysiloxanes represented by average unit formula (B2) below.

(R²²SiO_{3/2})ₐ(R²²₂SiO_{2/2})_{b}(R²²₃SiO_{1/2})_{c}(SiO_{4/2})_{d}(X²²O1/2)e... (B2)

In formula (B2), each R²² is independently a substituted or unsubstituted monovalent hydrocarbon group or a hydrogen atom. The monovalent hydrocarbon group of R²² is synonymous with that described above for the monovalent hydrocarbon group of R¹¹. Furthermore, in one molecule, at least one R²² is an aryl group. At least two R²² moieties in one molecule are hydrogen atoms.
In formula (B2), X²² is a hydrogen atom or an alkyl group. This alkyl group is synonymous with that described above for the alkyl group of X¹². In formula (B2), a is a positive number; b is 0 or a positive number; c is 0 or a positive number; d is 0 or a positive number; e is 0 or a positive number; b/a is a number in a range of 0 to 10; c/a is a number in a range of 0 to 5; d/(a + b + c + d) is a number in a range of 0 to 0.3; and e/(a + b + c + d) is a number in a range of 0 to 0.4.

As described above, examples of the silicon-containing compound (B) include the silane, the straight-chain organopolysiloxane (straight-chain organopolysiloxane (B)), and the branched-chain organopolysiloxane described above. One type of these may be used alone or two or more types of these may be used in combination.

### Branched-chain organopolysiloxane (C)

The branched-chain organopolysiloxane (C) is a branched-chain organopolysiloxane having an alkenyl group and an aryl group in one molecule.
Examples of these alkenyl group include alkenyl groups having from 2 to 18 carbons such as a vinyl group, allyl group, butenyl group, pentenyl group, hexenyl group, and octenyl group, and a vinyl group (hereinafter, also referred to as "Vi") is preferable.
The amount of alkenyl groups in one molecule is preferably from 2 to 12% by mass, and more preferably from 3 to 10% by mass.

In addition, the branched-chain organopolysiloxane (C) preferably has at least one aryl group, and it is preferable for at least 30 mol% and more preferable for at least 40 mol% of all of the silicon atom-bonded organic groups to be aryl groups.
Examples of the aryl group include aryl groups having from 6 to 18 carbons such as a phenyl group, tolyl group, and xylyl group, and a phenyl group is preferable.
As a result, damping of light that is caused by refraction, reflection, scattering, or the like of the resulting cured product becomes small, miscibility of the silicon-containing compound (A) having an aryl group and the silicon-containing compound (B) becomes excellent, and thus turbidity or the like is suppressed, thereby achieving excellent transparency of the cured product.

Examples of other groups binding to silicon atoms in the branched-chain organopolysiloxane (C) include substituted or unsubstituted monovalent hydrocarbon groups excluding alkenyl groups and aryl groups, and specific examples include alkyl groups having from 1 to 18 carbons such as a methyl group, ethyl group, n-propyl group, isopropyl group, n-butyl group, isobutyl group, sec-butyl group, tert-butyl group, various pentyl groups, various hexyl groups, various octyl groups, various decyl groups, cyclopentyl group, and cyclohexyl group; aralkyl groups having from 7 to 18 carbons such as a benzyl group and phenethyl group; and halogenated alkyl groups having from 1 to 18 carbons such as a 3-chloropropyl group and 3,3,3-trifluoropropyl group; and the like. The substance may also contain small amounts of other groups such as silicon atom-bonded hydroxyl groups or silicon atom-bonded alkoxy groups. Examples of these alkoxy groups include methoxy groups, ethoxy groups, propoxy groups, butoxy groups, and the like.

As such a branched-chain organopolysiloxane (C), an organopolysiloxane represented by average unit formula (C1) below is preferable.

(R³¹SiO_{3/2})ₐ(R³¹₂SiO_{2/2})_{b}(R³¹₃SiO_{1/2})_{c}(SiO_{4/2})_{d}(X³¹O_{1/2})e.......... (C1)

In formula (C1), each R³¹ is independently a substituted or unsubstituted monovalent hydrocarbon group. Examples of this monovalent hydrocarbon group include alkyl groups having from 1 to 18 carbons such as a methyl group, ethyl group, n-propyl group, isopropyl group, n-butyl group, isobutyl group, sec-butyl group, tert-butyl group, various pentyl groups, various hexyl groups, various octyl groups, various decyl groups, cyclopentyl group, and cyclohexyl group; alkenyl groups having from 2 to 18 carbons such as a vinyl group, allyl group, butenyl group, pentenyl group, hexenyl group, and octenyl group; aryl groups having from 6 to 18 carbons such as a phenyl group, tolyl group, and xylyl group; aralkyl groups having from 7 to 18 carbons such as a benzyl group and phenethyl group; and halogenated alkyl groups having from 1 to 18 carbons such as a 3-chloropropyl group and 3,3,3-trifluoropropyl group; and the like.
However, it is preferable for at least one R³¹ in one molecule to be an alkenyl group and for the amount of R³¹ in the form of alkenyl group to be from 2 to 12% by mass, and the amount is more preferably from 3 to 10% by mass.
In addition, it is also preferable for at least one R³¹ in one molecule to be an aryl group and for at least 30 mol% of all of the R³¹ moieties to be aryl groups, and it is more preferable for at least 40 mol% to be aryl groups. In formula (C1), X³¹ is a hydrogen atom or an alkyl group. This alkyl group is synonymous with that described above for the alkyl group of X¹².

In formula (C1), a is a positive number; b is 0 or a positive number; c is 0 or a positive number; d is 0 or a positive number; e is 0 or a positive number; b/a is a number in a range of 0 to 10; c/a is a number in a range of 0 to 5; d/(a + b + c + d) is a number in a range of 0 to 0.3; and e/(a + b + c + d) is a number in a range of 0 to 0.4.

The weight average molecular weight (Mw) of the branched-chain organopolysiloxane (C) is preferably from 1,000 to 300,000, and more preferably from 1,000 to 100,000.
The branched-chain organopolysiloxane (C) is an extremely viscous semi-solid material or a solid material, and the viscosity thereof is difficult to measure.

The content of the branched-chain organopolysiloxane (C) is preferably an amount at which the molar ratio of the silicon atom-bonded hydrogen atoms of the silicon-containing compound (B) having silicon atom-bonded hydrogen atoms (when the composition of the present invention also contains a silicon-containing compound having silicon atom-bonded hydrogen atoms, this silicon-containing compound is also included; this is the same hereinafter) and the alkenyl group of the branched-chain organopolysiloxane (C) (hereinafter, also referred to as "Si-H/Si-Vi molar ratio" for convenience) satisfies a range of 0.5 to 5.0, and more preferably a range of 0.5 to 1.5.
When the Si-H/Si-Vi molar ratio is within this range, the curability of the composition of the present invention is excellent, and the adhesion of the cured product is also excellent.

### Hydrosilylation reaction catalyst (D)

The hydrosilylation reaction catalyst (D) contained in the composition of the present invention is used in combination with the silicon-containing compound (B) having silicon atom-bonded hydrogen atoms (Si-H) and functions as a catalyst for accelerating the addition reaction (hydrosilylation reaction) with respect to the alkenyl groups of the branched-chain organopolysiloxane (C).
A conventionally known catalyst can be used as the hydrosilylation reaction catalyst (D). Examples include platinum catalysts, rhodium catalysts, palladium catalysts, and the like. Platinum catalysts are preferable. Specific examples of platinum catalysts include chloroplatinic acid, chloroplatinic acid-olefin complexes, chloroplatinic acid-divinyltetramethyldisiloxane complexes, chloroplatinic acid-alcohol coordination compounds, diketone complexes of platinum, platinum divinyltetramethyldisiloxane complexes, and the like. One type of these may be used alone or two or more types of these may be used in combination.
The content of the hydrosilylation reaction catalyst (D) is a catalytic amount; however, from the perspective of achieving excellent curability of the composition of the present invention, the content is preferably from 0.00001 to 0.1 parts by mass, and more preferably from 0.0001 to 0.01 parts by mass, per 100 parts by mass total of the silicon-containing compound (B) and the branched-chain organopolysiloxane (C) described above.

### Low-viscosity organopolysiloxane (E)

The composition of the present invention preferably contains a low-viscosity organopolysiloxane (E) having a viscosity of 50,000 mPa·s or less at 25°C. The adhesion of the cured product is excellent as a result of containing the low-viscosity organopolysiloxane (E). It is conceived that this is due to the fact that reducing the viscosity provides flexibility, which suppresses the occurrence of cracking and the like.
From the perspective of further enhancing adhesion of the cured product, the viscosity of the low-viscosity organopolysiloxane (E) at 25°C is preferably from 1,000 to 30,000 mPa·s.

A specific example of such a low-viscosity organopolysiloxane (E) is an organopolysiloxane represented by average unit formula (E1) below.

(R⁴¹SiO_{3/2})_{f}(R⁴¹₂SiO_{2/2})_{g}(R⁴¹₃SiO_{1/2})h(SiO_{4/2})ᵢ(X⁴¹O_{1/2})ⱼ........... (E1)

In formula (E1), each R⁴¹ is independently a substituted or unsubstituted monovalent hydrocarbon group. This monovalent hydrocarbon group is synonymous with that described above for the monovalent hydrocarbon group of _{R}³¹.
However, at least one R⁴¹ in one molecule is an alkenyl group, and the amount of the alkenyl group of R⁴¹ is preferably from 2 to 12% by mass, and more preferably from 3 to 10% by mass.
In addition, it is also preferable for at least 10 mol% of all of the R⁴¹ moieties in one molecule to be aryl groups.

In formula (E1), X² is a hydrogen atom or an alkyl group. Examples of the alkyl group include alkyl groups having from 1 to 18 carbons such as a methyl group, ethyl group, n-propyl group, isopropyl group, n-butyl group, isobutyl group, sec-butyl group, tert-butyl group, various pentyl groups, various hexyl groups, various octyl groups, various decyl groups, cyclopentyl group, and cyclohexyl group, and a methyl group is preferable.

In formula (E1), f is a positive number; g is 0 or a positive number; h is 0 or a positive number; i is 0 or a positive number; j is 0 or a positive number; g/f is a number in a range of 0 to 10; h/f is a number in a range of 0 to 0.5; i/(f + g + h + i) is a number in a range of 0 to 0.3; and j/(f + g + h + i) is a number in a range of 0 to 0.4.

The weight average molecular weight (Mw) of the low-viscosity organopolysiloxane (E) is preferably from 500 to 50,000, and more preferably from 1,000 to 30,000.

Furthermore, the content of the low-viscosity organopolysiloxane (E) is not particularly limited; however, the content is preferably from 5 to 50 parts by mass, and more preferably from 10 to 30 parts by mass, per 100 parts by mass total of the silicon-containing compound (B) and the branched-chain organopolysiloxane (C) described above.

### Curing retarder (F)

The composition of the present invention may further contain a curing retarder (F). The curing retarder (F) is a component for adjusting the curing speed or the working life of the composition of the present invention, and examples include alcohol derivatives containing carbon-carbon triple bonds such as 3-methyl-l-butyn-3-ol, 3,5-dimethyl-1-hexyn-3-ol, phenylbutynol, and 1-ethynyl-1-cyclohexanol; enyne compounds such as 3-methyl-3-penten-1-yne and 3,5-dimethyl-3-hexen-1-yne; alkenyl group-containing low molecular weight siloxanes such as tetramethyltetravinylcyclotetrasiloxane and tetramethyltetrahexenylcyclotetrasiloxane; alkyne-containing silanes such as methyl-tris(3-methyl-1-butyn-3-oxy)silane and vinyl-tris(3-methyl-1-butyn-3-oxy)silane; and the like. One type of these may be used alone or two or more types of these may be used in combination.
The content of the curing retarder (F) is selected appropriately in accordance with the usage method or the like of the composition of the present invention but is, for example, preferably from 0.00001 to 0.1 parts by mass, and more preferably from 0.0001 to 0.01 parts by mass, per 100 parts by mass total of the silicon-containing compound (B) and the branched-chain organopolysiloxane (C) described above.

### Adhesion imparting agent (G)

The composition of the present invention may further contain an adhesion imparting agent (G).
An example of the adhesion imparting agent (G) is a silane coupling agent. Specific examples of the silane coupling agent include aminosilane, vinyl silane, epoxy silane, methacrylic silane, isocyanate silane, iminosilane, reaction products thereof, and compounds obtained by reactions between these substances and polyisocyanate. Epoxy silane is preferable.
The epoxy silane is not particularly limited as long as it is a compound having an epoxy group and an alkoxysilyl group, and examples include dialkoxyepoxysilanes such as γ-glycidoxypropyl methyl dimethoxysilane, γ-glycidoxypropyl ethyl diethoxysilane, γ-glycidoxypropyl methyl diethoxysilane, and [3-(3,4-epoxycyclohexyl)ethylmethyldimethoxysilane; trialkoxyepoxysilanes such as γ-glycidoxypropyl trimethoxysilane and [β-(3,4-epoxycyclohexyl)ethyltrimethoxysilane; and the like. In addition, the adhesion imparting agent (G) may be a dehydration condensation product of the epoxy silane described above, examples of which include epoxy silane dehydration condensation products formed by performing dehydration condensation on γ-glycidoxypropyl trimethoxysilane, phenyltrimethoxysilane, and 1,3-divinyl-1,1,3,3-tetra methyldisiloxane.
The content of the adhesion imparting agent (G) is not particularly limited but is preferably from 0.5 to 10 parts by mass, and more preferably from 1 to 5 parts by mass, per 100 parts by mass total of the silicon-containing compound (B) and the branched-chain organopolysiloxane (C) described above.

### Other components

The composition of the present invention may further contain additives, as necessary, in addition to the components described above in the range that does not inhibit the object and the effect of the present invention.
For example, when the composition of the present invention is used as a composition for sealing an optical semiconductor, a phosphor may be contained. Examples of the phosphor include inorganic phosphors. Specific examples thereof include YAG phosphors, ZnS phosphors, Y₂O₂S phosphors, red light emitting phosphors, blue light emitting phosphors, green light emitting phosphors, and the like.

The production method of the composition of the present invention is not particularly limited, and an example is a method of producing the composition by mixing the essential components and optional components described above.
In addition, the method of obtaining a cured product by curing the composition of the present invention is also not particularly limited, and an example is a method of heating the composition of the present invention for 10 to 720 minutes at 80 to 200°C.

The composition of the present invention may be used as an adhesive, a primer, a sealant, or the like in fields such as, for example, display materials, optical recording media materials, optical device materials, optical part materials, optical fiber materials, optical-electronic function organic materials, and semiconductor integrated circuit peripheral materials.

In particular, the composition of the present invention can be suitably used as a sealing material for an optical semiconductor since it has excellent adhesion and the cured product thereof demonstrates good transparency and a high refractive index.
The optical semiconductors to which the composition of the present invention can be applied are not particularly limited, and examples include LEDs, organic electroluminescent elements (organic electroluminescence (EL)), laser diodes, LED arrays, and the like.
Examples of methods of use of the composition of the present invention as a composition for sealing an optical semiconductor include applying the composition of the present invention to an optical semiconductor, heating the optical semiconductor to which the composition of the present invention has been applied, and curing the composition of the present invention.
At this time, the method of applying and curing the composition of the present invention is not particularly limited, and examples include a method using a dispenser, a potting method, screen printing, transfer molding, injection molding, and the like.
Since the cured product of the composition of the present invention exhibits excellent effect of suppressing occurrence of spots while the transparency is maintained, the composition of the present invention can be suitably used as a sealing material for sealing an LED for COB, which is large in size and easily causes spots.

### Examples

The present invention will be described in detail hereinafter using working examples, but the present invention is not limited to these examples.

### Production of Si-H straight-chain organopolysiloxane B-1

First, 100 g of a straight-chain organopolysiloxane having a silanol group represented by formula (B-0) below, 1 g of 1,1,3,3-tetramethyldisiloxane, and 0.1 g of trifluoromethanesulfonic acid were charged into a flask with a stirrer and a reflux cooling tube, and the mixture was stirred and heated for two hours at 50°C. Next, 150 g of toluene was added, and the water that was produced was discharged to the outside of the system. After the toluene layer was washed with water three times, the layer was concentrated under reduced pressure to obtain a straight-chain organopolysiloxane B-1 represented by formula (B-1) below.

HO(Ph₂SiO)₃(Me₂SiO)₃H............................... (B-0)

HMe₂SiO(Ph₂SiO)₅₀₍Me₂SiO)₅₀SiMe₂H..................... (B-1)

### Production of Si-H branched-chain organopolysiloxane B-2

First, 194.6 g of phenyltrimethoxysilane and 0.22 g of trifluoromethanesulfonic acid were charged into a four-neck flask with a stirrer, a reflux cooling tube, a charging port, and a thermometer and mixed, and 13.3 g of water was dropped into the solution while stirring over the course of 15 minutes. After dropping was complete, the solution was heat-refluxed for one hour. After the solution was cooled to room temperature, 118.6 g of 1,1,3,3-tetramethyldisiloxane was added, and 88.4 g of acetic acid was dropped into the solution while stirring over the course of 30 minutes. After dropping was complete, the solution was heated to 50°C while stirring and reacted for three hours. After the solution was cooled to room temperature, toluene and water were added, mixed well, and left to stand, and the water layer was separated. After the toluene solution layer was washed with water three times, the solution was concentrated under reduced pressure to obtain a branched-chain organopolysiloxane B-2, which is a methylphenylhydrogenoligosiloxane in a liquid state at 25°C represented by the following average unit formula (B-2).

(HMe₂SiO_{1/2})_{0.6}(PhSiO_{3/2})0.4.......................... (B-2)

### Production of Si-Vi branched-chain organopolysiloxane C-1

First, 21.4 g of 1,3-divinyl-1,1,3,3-tetramethyldisiloxane, 60 g of water, 0.14 g of trifluoromethanesulfonic acid, and 200 g of toluene were charged into a four-neck flask with a stirrer, a reflux cooling tube, a charging port, and a thermometer and mixed, and 151.5 g of phenyltrimethoxysilane was dropped into the solution while stirring over the course of one hour. After dropping was complete, the solution was heat-refluxed for one hour. After cooling, the bottom layer was separated, and the toluene solution layer was washed with water three times. Next, 100 g of a 5% of sodium hydrogen carbonate aqueous solution was added to the water-washed toluene solution layer, and the solution was heated to 75°C while stirring and then refluxed for one hour. After cooling, the bottom layer was separated, and the toluene solution layer of the top layer was washed with water three times. The remaining toluene solution layer was concentrated under reduced pressure to obtain a branched-chain organopolysiloxane C-1, which is a methylphenylvinylpolysiloxane resin represented by average unit formula (C-1) below and is in a semi-solid state at 25°C.

(ViMe₂SiO_{1/2})_{0.25}(PhSiO_{3/2})0.75............................ (C-1)

### Working Examples 1 to 9 and Comparative Examples 1 and 2 Production of curable resin composition

The components shown in Table 1 below were used in the amounts shown in the table (units: parts by mass), and these components were mixed uniformly with a vacuum stirrer to produce a curable resin composition. Note that, in working examples and comparative examples, "Si-H/Si-Vi molar ratio" described above was adjusted to 1.0.

### Evaluation

To 100 parts by mass of the produced curable resin composition, 5 parts by mass of a phosphor (YAG450C, manufactured by Nemoto Lumi-Materials Co., Ltd.) was added and uniformly mixed to obtain a composition for evaluation. The obtained composition for evaluation was subjected to evaluations described below. The evaluation results are shown in Table 1 below.

### Linear transmittance

The obtained composition for evaluation was heated and cured for two hours at 150°C to obtain a cured product (thickness = 2.0 mm). The linear transmittance at a wavelength of 400 nm (units: %) was measured for the obtained cured product in accordance with JIS K 0115:2004 using an ultraviolet-visible (UV-Vis) absorption spectrometer (manufactured by the Shimadzu Corporation). The composition can be evaluated as having excellent "transparency" when the linear transmittance value is 80% or greater.

### Spots suppression

First, a silicone-based damming agent (KER-2000DAM, manufactured by Shin-Etsu Chemical Co., Ltd.) was coated in a shape of 7 mm × 7 mm frame (thickness: 1 mm) on a 50 mm × 50 mm aluminum plate, and heated and cured for one hour at 150°C to form a dam. Thereafter, the obtained composition for evaluation was coated within the formed dam in a manner that the thickness was roughly 1 mm, and heated and cured for two hours at 150°C. Appearance of the cured product was visually observed. The results of the observation was evaluated according to the following criteria. When the evaluation result is "⊚" or "○", the composition is evaluated as having excellent effect of suppressing occurrence of spots.
⊚ : No spots were observed in the cured product
○: From 1 to 5 spots were observed in the cured product
×: Six or more spots were observed in the cured product

**[TABLE 1]**

| | | Working Examples | | | | | | | | | Comparative Examples | |
|---|---|---|---|---|---|---|---|---|---|---|---|---|
| | | 1 | 2 | 3 | 4 | 5 | 6 | 7 | 8 | 9 | 1 | 2 |
| Si-OH-based | A-1 | 50 | 50 | 50 | | | | | | | | |
| | A-2 | | | | 50 | 50 | 50 | | | | | |
| | A-3 | | | | | | | 50 | 50 | 50 | | |
| Si-H-based | B-1 | 50 | 25 | | 25 | 50 | 25 | 25 | | 50 | 50 | 50 |
| | B-2 | 150 | | | 150 | | | 150 | | | 150 | 150 |
| | B-3 | | 120 | | | 120 | | | 120 | | | |
| | B-4 | | | 95 | | | 95 | | | 95 | | |
| Si-Vi-based | C-1 | 200 | 200 | 5.5 | 200 | 200 | 5.5 | 200 | 200 | 5.5 | 200 | 200 |
| Hydrosilylation reaction catalyst D | | 0.2 | | | | | | | | | 0.2 | |
| Low-viscosity organopolysiloxane E | | 50 | 50 | | 50 | 50 | | 50 | 50 | | 50 | 50 |
| Curing retarder F | | 0.001 | | | | | | | | | 0.001 | |
| Adhesion imparting agent G | | 3 | | | | | | | | | 3 | |
| Silica | | | | | | | | | | | 4.5 | |
| Linear transmittance [%] | | 89.0 | 88.0 | 88.0 | 89.0 | 88.0 | 88.0 | 70.0 | 65.0 | 70.0 | 40.0 | 88.0 |
| Spots suppression | | ⊚ | ⊚ | ⊚ | ○ | ○ | ○ | ○ | ○ | ○ | ○ | × |

The components shown in Table 1 are as follows.

Si-OH-based
- A-1: Straight-chain organopolysiloxane having a silanol group and a phenyl group, represented by formula (A-1) below HO(Ph₂SiO)₃(Me₂SiO)₃H...(A-1)
- A-2: Branched-chain organopolysiloxane having a silanol group and a phenyl group (trade name: 217 Flake, manufactured by Dow Corning Toray Co., Ltd.; content of silanol groups: 3.5% by mass; content ratio of phenyl groups in all silicon atom-bonded organic groups: 50 mol%; Mw: 1,000)
- A-3: Diphenylsilanediol represented by formula (A-3) below

   Ph₂Si(OH)₂ (A-3)

### Si-H-based

- B-1: Straight-chain organopolysiloxane B-1 described above (content of silicon atom-bonded hydrogen atoms: 0.01% by mass; content ratio of phenyl groups in all silicon atom-bonded organic groups: 50 mol%; Mw: 15,000; viscosity: 10,000 mPa·s)
- B-2: Branched-chain organopolysiloxane B-2 described above (content of silicon atom-bonded hydrogen atoms: 0.38% by mass; content ratio of phenyl groups in all silicon atom-bonded organic groups: 60 mol%; Mw: 4,000; viscosity: 1,200 mPa·s)
- B-3: Straight-chain organopolysiloxane B-3 represented by formula (B-3) below

   HMe₂SiO(Ph₂SiO)₂SiMe₂H... (B-3)
- B-4: Straight-chain organopolysiloxane B-4 represented by formula (B-4) below

   HMe₂SiO(Ph₂SiO)SiMe₂H... (B-4)

### Si-Vi-based

- C-1: Branched-chain organopolysiloxane C-1 described above (content of vinyl groups: 4.0% by mass; content ratio of phenyl groups in all silicon atom-bonded organic groups: 50 mol%; Mw: 1,500; viscosity: the substance was an extremely viscous semi-solid material and the viscosity could not be measured)

- Hydrosilylation reaction catalyst D: Platinum divinyltetramethyldisiloxane complex (manufactured by N.E. Chemcat Corporation)
- Low-viscosity organopolysiloxane E: Organopolysiloxane represented by average unit formula (E-1) below (content of vinyl groups: 10% by mass; content ratio of phenyl groups in all silicon atom-bonded organic groups: 31 mol%; Mw: 1,100; viscosity: 3,000 mPa·s)

   (PhSiO_{3/2})₀.₃₇(ViMe₂SiO_{1/2})₀.₆₃... (E-1)
- Curing retarder E: 3-Methyl-1-butyn-3-ol (manufactured by Tokyo Chemical Industry Co., Ltd.)
- Adhesion imparting agent G: Epoxy silane dehydration condensation product formed by performing dehydration condensation on γ-glycidoxypropyltrimethoxysilane (KBM-403, manufactured by Shin-Etsu Chemical Co., Ltd.), phenyltrimethoxysilane (KBM-103, manufactured by Shin-Etsu Chemical Co., Ltd.), and 1,3-divinyl-1,1,3,3-tetramethyldisiloxane
- Silica: Fumed silica (R976S, manufactured by Nippon Aerosil)

As is clear from the results shown in Table 1, Comparative Example 2 that did not contain Si-OH-based A-1 to A-4 and that did not contain silica exhibited poor effect of suppressing occurrence of spots although transparency was relatively good.
Furthermore, Comparative Example 1 that did not contain A-1 to A-4 but contained silica exhibited better effect of suppressing occurrence of spots but exhibited significant reduction in transparency.

On the other hand, Working Examples 1 to 10 that contained Si-OH-based A-1 to A-4 but contained no silica exhibited excellent effect of suppressing occurrence of spots as well as good transparency.
Among these, Working Examples 1 to 6 which used A-1 (straight-chain organopolysiloxane) or A-2 (branched-chain organopolysiloxane) exhibited even better transparency than those of Working Examples 7 to 9 which used A-3 (diphenylsilanediol).
Furthermore, Working Examples 1 to 3 which used A-1 exhibited even better effect of suppressing occurrence of spots than those of Working Examples 4 to 9 which used A-2 or A-3.

## Claims

1. A curable resin composition comprising:
a silicon-containing compound having a silanol group and an aryl group (A);
a silicon-containing compound having at least two silicon atom-bonded hydrogen atoms and at least one aryl group in one molecule (B);
a branched-chain organopolysiloxane having an alkenyl group and an aryl group (C); and
a hydrosilylation reaction catalyst (D).

2. The curable resin composition according to claim 1, wherein
the silicon-containing compound (A) is a straight-chain organopolysiloxane represented by formula (A1) below:
HOR¹¹₂SiO(R¹¹₂SiO)ₙ₁SiR¹¹₂OH ... (A1)
wherein, each R¹¹ is independently a substituted or unsubstituted monovalent hydrocarbon group having no aliphatic unsaturated bond, and at least one R¹¹ is an aryl group; and
n1 is a positive number of 1 or greater.

3. The curable resin composition according to claim 1 or 2, wherein the branched-chain organopolysiloxane (C) is an organopolysiloxane represented by average unit formula (C1) below:
(R³¹SiO_{3/2})ₐ(R³¹₂SiO_{2/2})_{b}(R³¹₃SiO_{1/2})_{c}(SiO_{4/2})_{d}(X³¹O_{1/2})e... (C1)
wherein,
each R³¹ is independently a substituted or unsubstituted monovalent hydrocarbon group; however, in one molecule, at least one R³¹ is an alkenyl group, and at least one R³¹ is an aryl group;
X³¹ is a hydrogen atom or an alkyl group; and
a is a positive number; b is 0 or a positive number; c is 0 or a positive number; d is 0 or a positive number; e is 0 or a positive number; b/a is a number in a range of 0 to 10; c/a is a number in a range of 0 to 5; d/(a + b + c + d) is a number in a range of 0 to 0.3; and e/(a + b + c + d) is a number in a range of 0 to 0.4.

4. The curable resin composition according to any one of claims 1 to 3, further comprising
a low-viscosity organopolysiloxane (E) having a viscosity of 50,000 mPa·s or less at 25°C.

5. The curable resin composition according to any one of claims 1 to 4, wherein the composition is a composition for sealing an optical semiconductor element.
